# EUROPEAN PATENT SPECIFICATION

(11) **EP 2 679 639 B1**
(45) Date of publication and mention of the grant of the patent: **19.10.2016**
(21) Application number: 12749676.8
(22) Date of filing: 24.02.2012
(51) Int. Cl.: C09D 1/00, C09D 1/02, H01B 1/22, B41M 1/00

(54) **CONDUCTIVE INK COMPOSITION FOR OFFSET OR REVERSE-OFFSET PRINTING**
LEITFÄHIGE TINTENZUSAMMENSETZUNG FÜR OFFSET- ODER REVERSE-OFFSET-DRUCK
COMPOSITION D'ENCRE CONDUCTRICE POUR IMPRESSION OFFSET OU OFFSET INVERSE

(30) Priority: 25.02.2011 KR 20110017016; 23.02.2012 KR 20120018482
(43) Date of publication of application: 01.01.2014
(73) Proprietor: Hanwha Chemical Corporation, Seoul 100-220 (KR)
(72) Inventor: PAIK, Choong-Hoon, Daejeon 305-720 (KR); SON, Won II, Daejeon 305-759 (KR); OH, Seok-Heon, Daejeon 305-720 (KR); KIM, Eui Duk, Daejeon 305-720 (KR)
(74) Representative: Laufhütte, Dieter
(86) International application number: PCT/KR2012/001411
(87) International publication number: WO 2012/115475

(56) References cited:
- EP-A1- 1 860 163
- WO-A1-03/106573
- JP-A- H11 158 426
- JP-A- 2005 126 608
- JP-A- 2009 024 066
- KR-A- 20060 108 875
- KR-A- 20080 088 712
- KR-A- 20100 014 950

## Description

### [Technical Field]

The following disclosure relates to a conductive ink composition for offset or reverse-offset printing.

### [Background Art]

As electronic devices, information terminal devices, and the like have a smaller size and a smaller weight, electronic components used in the devices tend to be gradually smaller. Therefore, sizes of wiring patterns for being mounted in the electronic components are also gradually decreased, and widths of the wiring patterns or distances between the wiring patterns are gradually decreased.

An optical patterning method based on an exposing process and an etching process has been mainly used in order to form high-definition wiring patterns in the electronic component. However, the optical patterning method is not efficient since it unnecessarily wastes a lot of materials, requires a multistep process, and needs complicated processes such as using photoresist, developing liquids, or etching solution, and the like. Moreover, since a large-area mask needs to be used in the optical patterning method, it is difficult to apply a new design to a production line in the least amount of time. Therefore, in order to overcome disadvantages of the optical patterning method, there was developed a method of forming metal wirings through printing using an ink so that patterns are formed directly on the substrate without a mask.

An offset printer used in forming the metal wirings consists of an ink supply part, a columnar blanket and a printing plate. The ink patterns are transferred onto a substrate to be printed by the columnar blanket.

However, due to the trend of small sizes and high integration of products, degradation in transfer precision, such as enlargement in the line width of an ink pattern due to swelling of the blanket and the like, have emerged as serious problems. Hence, it is urgent to develop a conductive ink composition capable of forming ultra-fine metal patterns having a very small wiring width or a distance between wiring patterns.

### [Disclosure]

### [Technical Problem]

An object of the present invention is to provide a conductive ink composition for offset or reverse-offset printing, capable of having excellent coatability onto a blanket, preventing swelling of the blanket, and having excellent transferability onto substrates to be printed including glass, and a conductive ink composition capable of having excellent dispersion stability, forming metal wirings having ultrafine patterns, and having excellent resistivity.

Hereinafter, an ink composition of the present invention will be described in detail. Here, unless indicated otherwise, the terms used in the specification including technical and scientific terms have the same meaning as those that are usually understood by those who skilled in the art to which the present invention pertains, and detailed description of the known functions and constitutions that may obscure the gist of the present invention will be omitted.

### [Technical Solution]

A conductive ink composition according to the present invention is characterized by being an ink composition for offset or reverse-offset printing, and contains a high boiling point solvent having a boiling point of 180 to 250°C and a dispersion assistant solvent having a boiling point of 50 to 150°C, together with metal particles and tert-butyl alcohol, which is a main solvent.

In the conductive ink composition according to an embodiment of the present invention, the dispersion assistant solvent may have a solubility parameter of 9 to 11.

The conductive ink composition according to an embodiment of the present invention may contain tert-butyl alcohol as a main solvent, together with metal particles for giving conductivity thereto. The tert-butyl alcohol may be contained in a content of 40 to 65 wt% based on the total weight of the ink composition.

The tert-butyl alcohol constitutes a medium of the ink composition together with the high boiling point solvent and the dispersion assistant solvent, which will be described later, and thus, provides excellent coatability onto a material of the blanket and prevents swelling of the blanket.

The conductive ink composition of the present invention can have excellent coatability onto a polydimethylsiloxane (PDMS) material blanket and can prevent swelling of the PDMS material blanket.

In the case where other organic solvents having a similar solubility parameter (hereinafter, SP) to tert-butyl alcohol (SP: 10.6) is used as a main solvent, a conductive ink composition may not exhibit sufficient coatability and transferability onto the material of the blanket even though it contains the high boiling point solvent and the dispersion assistant solvent according to the present invention.

For example, in the case where solvents, such as isobutanol (SP: 10.5), sec-butanol (SP: 10.8), ethoxy ethanol (SP: 10.5), isopropyl alcohol (SP: 11.5), and propylene glycol monomethyl ether acetate (SP: 9.2), are used as the main solvent, coatability of the conductive ink composition may be severely deteriorated. In the case where solvents having a low SP, such as toluene (SP: 8.9) and isopropyl acetate (SP: 8.4) are used as a main solvent, coatability is excellent but swelling of the blanket is worse.

In the conductive ink composition according to an embodiment of the present invention, the t-butyl alcohol may be contained in a content of 40 to 65 wt%, preferably 40 to 60 wt%, and more preferably 40 to 50 wt% based on the total weight of the ink composition. If the content of the t-butyl alcohol is below 40 wt%, coatability of the conductive ink composition may be at risk of deterioration. Further, if above 65 wt%, electric properties of conductive patterns to be printed may be at risk of deterioration.

As such, the conductive ink composition according to the present invention employs tert-butyl alcohol as a main solvent, and a high boiling point solvent having a boiling point of 180 to 250°C and a dispersion assistant solvent having a boiling point of 50 to 150°C, as a sub solvent, and thus, can obtain excellent coatability and transferability, prevent swelling of a material of the blanket, and secure the waiting time of 30 seconds or longer after coating and before transferring. Further, the conductive ink composition according to the present invention is characterized by forming a uniform coating surface, preventing pinholes, improving dispersibility thereof, and preventing nozzles from being blocked.

For a substantial example, the high boiling point solvent may be at least one selected from terpineol, ethyl carbitol acetate, and butyl carbitol acetate.

The conductive ink composition according to an embodiment of the present invention may contain the high boiling point solvent in a content of 3 to 15 wt%, preferably 3 to 10 wt%, and more preferably 5 to 10 wt%.

The conductive ink composition according to an embodiment of the present invention contains the high boiling point solvent having a boiling point of 180 to 250°C in a content of 3 to 15 wt% based on the total weight of the ink composition while employing tert-butyl alcohol as the main solvent, and thus, can secure the waiting time of 30 seconds or longer after coating and before transferring, can form a uniform coating surface by preventing agglomeration of the high boiling point solvent, and prevent pinholes.

In the conductive ink composition according to an embodiment of the present invention, the dispersion assistant solvent may have a boiling point of 50 to 150°C and a solubility parameter of 9 to 11. For a substantial example, the dispersion assistant solvent may be at least one selected from acetone and propylene glycol monomethyl ether acetate.

The conductive ink composition according to an embodiment of the present invention may contain the dispersion assistant solvent in a content of 10 to 30 wt%, preferably 10 to 20 wt%, and more preferably 15 to 20 wt%.

As such, the conductive ink composition according to an embodiment of the present invention contains a dispersion assistant solvent having a boiling point of 50 to 150°C and a solubility parameter of preferably 9 to 11, in a content of 10 to 30 wt% based on the total weight of the ink composition while employing tert-butyl alcohol as a main solvent, and thus, can prevent swelling of PDMS, improve dispersibility thereof, prevent nozzles from being blocked by controlling volatile characteristics, and form a uniform coating surface.

The conductive ink composition according to an embodiment of the present invention employs the metal particles for giving conductivity thereto, and the metal particles may be copper particles, silver particles, or a mixture particles thereof, having an average particle size of 5nm to 100nm. The metal particles may include metal particles prepared by a liquid phase reduction method.

The conductive ink composition according to an embodiment of the present invention may contain the metal particles in a content of 20 to 40 wt%, preferably 20 to 35 wt%, and more preferably 25 to 35 wt%, based on the total weight of the ink composition.

The conductive ink composition according to an embodiment of the present invention may contain the metal particles in a content of 20 to 40 wt% based on the total weight of the ink composition. When the ink composition contains the metal particles of 20 to 40 wt%, a film thickness after coating and transferring is about 200nm or thicker, so that excellent electric conductivity can be obtained after firing, and here, the film thickness is maintained to be 500nm or thinner, so that very thin fine conductive patterns can be formed.

The conductive ink composition according to an embodiment of the present invention may further contain a binder and a dispersant.

In the conductive ink composition according to an embodiment of the present invention, the binder enhances binding strength between sintered ink patterns and a substrate on which the ink patterns are located. A binder resin that is commonly used in a field of ink composition easily dissolved in the above-described medium may be used for the binder. For example, the binder may be at least one material selected from phenol based resins and acrylic based resins. The acrylic based resins may include polyacrylic acid resin or polyacrylic ester resin, and the phenol based resins may include alkyl phenol based resins. The alkyl phenol based resins may include alkyl phenol-formaldehyde resin.

In the conductive ink composition according to an embodiment of the present invention, the binder may be contained in a content of 0.3 to 2 wt% and preferably 0.5 to 1.5 wt% based on the total weight of the ink composition, in order to obtain sufficient binding strength and prevent a deterioration in densification between the metal particles at the time of sintering.

In the conductive ink composition according to an embodiment of the present invention, the dispersant for improving dispersion stability may be a copolymer having an acid value of 50mg KOH/g or higher and an amine value of 100mg KOH/g or lower. For example, the dispersant may be a copolymer having an acid value of 50mg KOH/g to 200mg KOH/g and an amine value of 0mg KOH/g to 100mg KOH/g. For a substantial example, BYK102 (acid value: 101mg KOH/g, amine value: 0mg KOH/g), BYK110 (acid value: 53mg KOH/g, amine value: 0mg KOH/g), BYK145 (acid value: 76mg KOH/g, amine value: 71mg KOH/g), BYK180 (acid value: 94mg KOH/g, amine value: 94mg KOH/g), BYK995 (acid value: 53mg KOH/g, amine value: 0mg KOH/g), and BYK996 (acid value: 71mg KOH/g, amine value: 0mg KOH/g), which are commercial products from BYK Chemie Company, satisfying the above acid values and amine values, may be used as the dispersant.

The conductive ink composition according to an embodiment of the present invention may contain the dispersant in a content of 1 to 5 wt%, and preferably 1 to 3 wt% based on the total weight of the ink composition.

According to the conductive ink composition according to an embodiment of the present invention, conductive ink patterns may be printed as a target substrate by the PDMS material blanket. In addition, an electrode for a transistor, such as, a liquid crystal display thin film transistor (LCD TFT) or an organic field-effect transistor (OTFT), or a solar cell can be effectively formed by using the conductive ink composition according to an embodiment of the present invention. Here, the electrode for a solar cell may include a front electrode, a rear electrode, or a bus bar electrode for the solar cell.

### [Advantageous Effects]

The conductive ink composition according to the present invention can have excellent coatability onto a material of the blanket, particularly, a material of the PDMS blanket, and excellent stability onto the material of the blanket, thereby preventing swelling of the blanket. Further, conductive ink composition according to the present invention can obtain excellent transferability, secure the waiting time of 30 seconds or longer, form ultrafine metal patterns having a uniform coating surface and high electric conductivity, prevent pinholes, obtain excellent dispersion stability, and prevent nozzles from being blocked.

### [Description of Drawings]

FIG. 1 shows optical pictures of coating ((a) of FIG. 1) and transferring ((b) of FIG. 1) results using an ink composition according to Example 1 of the present invention;
FIG. 2 shows optical pictures of coating ((a) of FIG. 2) and transferring ((b) of FIG. 2) results using an ink composition according to Comparative example 1 of the present invention;
FIG. 3 shows optical pictures of coating ((a) of FIG. 3) and transferring ((b) of FIG. 3) results using an ink composition according to Comparative example 2 of the present invention;
FIG. 4 shows pictures obtained by observing a surface of a glass substrate ((a) of FIG. 4) and a surface of a blanket ((b) of FIG. 4) after transferring, in pattern transferring results using the ink composition according to Example 1 of the present invention;
FIG. 5 shows pictures obtained by observing a surface of a glass substrate ((a) of FIG. 5) and a surface of a blanket ((b) of FIG. 5) after transferring, in pattern transferring results using the ink composition according to Example 2 of the present invention;
FIG. 6 shows pictures obtained by observing a surface of a glass substrate ((a) of FIG. 6) and a surface of a blanket ((b) of FIG. 6) after transferring, in pattern transferring results using the ink composition according to Example 3 of the present invention; and
FIG. 7 shows pictures obtained by observing a surface of a glass substrate ((a) of FIG. 7) and a surface of a blanket ((b) of FIG. 7) after transferring, in pattern transferring results using the ink composition according to Comparative example 3.

### [Best Mode]

### [Example 1]

30 wt% of copper metal particles having an average particle size of 20nm, 47 wt% of tert-butyl alcohol as a main solvent, 5 wt% of terpineol as a high boiling point solvent, 15 wt% of propylene glycol monomethyl ether acetate as a dispersion assistant solvent, 1 wt% of polyacrylic acid resin (Aldrich, Mw: 1800 or less) as a binder, and 2 wt% of BYK180 (copolymer having an acid value of 94mg KOH/g and an amine value of 94 mg KOH/g) as a dispersant were mixed, and then the mixture was milled by using a boll mill for 2 hours. The thus obtained material was used as an ink for printing.

### [Example 2]

30 wt% of copper metal particles having an average particle size of 20nm, 42 wt% of tert-butyl alcohol as a main solvent, 10 wt% of terpineol as a high boiling point solvent, 15 wt% of propylene glycol monomethyl ether acetate as a dispersion assistant solvent, 1wt% of polyacrylic acid resin (Aldrich, Mw: 1800 or less) as a binder, and 2 wt% of BYK180 (copolymer having an acid value of 94mg KOH/g and an amine value of 94 mg KOH/g) as a dispersant were mixed, and then the mixture was milled by using a boll mill for 2 hours. The thus obtained material was used as an ink for printing.

### [Example 3]

30 wt% of copper metal particles having an average particle size of 20nm, 47 wt% of tert-butyl alcohol as a main solvent, 5 wt% of terpineol as a high boiling point solvent, 15wt% of acetone as a dispersion assistant solvent, 1 wt% of alkyl phenol-formaldehyde resin (Tackirol-101) as a binder, and 2 wt% of BYK110 (copolymer having an acid value of 53 mg KOH/g and an amine value of 0 mg KOH/g) as a dispersant were mixed, and then the mixture was milled by using a boll mill for 2 hours. The thus obtained material was used as an ink for printing.

### [Comparative Example 1]

An ink for printing was prepared by the same method as Example 1 except that toluene was used as a main solvent.

### [Comparative Example 2]

An ink for printing was prepared by the same method as Example 1 except that ethanol was used as a main solvent.

### [Comparative Example 3]

30 wt% of copper metal particles having an average particle size of 20nm, 52 wt% of tert-butyl alcohol as a main solvent, 15 wt% of propylene glycol monomethyl ether acetate as a dispersion assistant solvent, 1wt% of polyacrylic acid resin (Aldrich, Mw: 1800 or less) as a binder, and 2 wt% of BYK110 (copolymer having an acid value of 53 mg KOH/g and an amine value of 0 mg KOH/g) as a dispersant were mixed without using a high boiling point solvent, and then the mixture was milled by using a boll mill for 2 hours. The thus obtained material was used as an ink for printing.

### [Comparative Example 4]

30 wt% of copper metal particles having an average particle size of 20nm, 62 wt% of tert-butyl alcohol as a main solvent, 5 wt% of terpineol as a high boiling point solvent, 1 wt% of polyacrylic acid resin (Aldrich, Mw: 1800 or less) as a binder, and 2 wt% of BYK110 (copolymer having an acid value of 53 mg KOH/g and an amine value of 0 mg KOH/g) as a dispersant were mixed without using a dispersant assistant solvent, and then the mixture was milled by using a boll mill for 2 hours. The thus obtained material was used as an ink for printing.

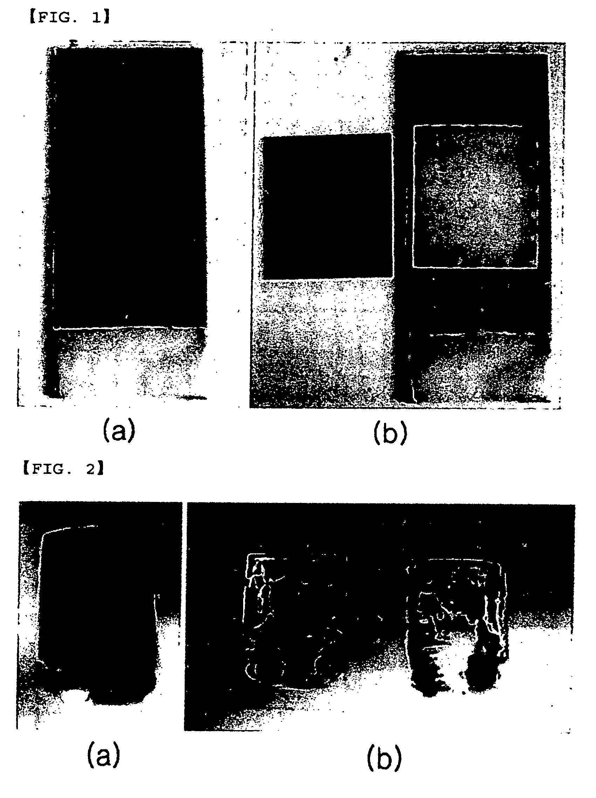

FIG. 1 shows observation results when the conductive ink composition according to Example 1 of the present invention was coated on a PDMS substrate, which was then transferred onto a glass substrate. As shown in FIG. 1, it can be seen that the conductive ink composition according to the present invention had excellent coatability onto the PDMS substrate and also had excellent transferability thereonto.

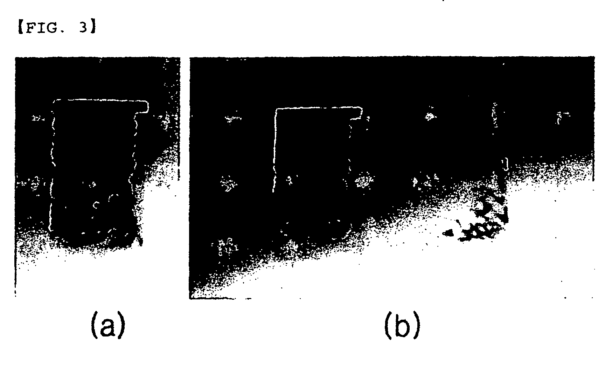

FIG. 2 and FIG. 3 show observation results when a conductive ink composition according to Comparative example 1 and a conductive ink composition according to Comparative example 2 each were coated on a PDMS substrate, which was then transferred onto a glass substrate. As shown in FIGS. 2 and 3, it can be confirmed that the ink composition not containing tert-butyl alcohol as a main solvent had very deteriorated coatability onto a PDMS substrate and very deteriorated transferability thereto even though it contains the high boiling point solvent and the dispersion assistant solvent of the present invention.

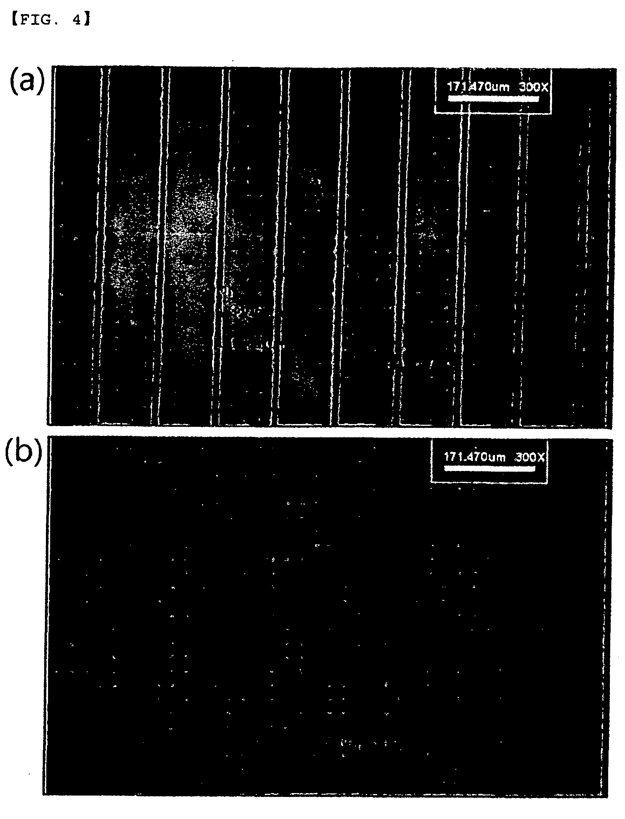

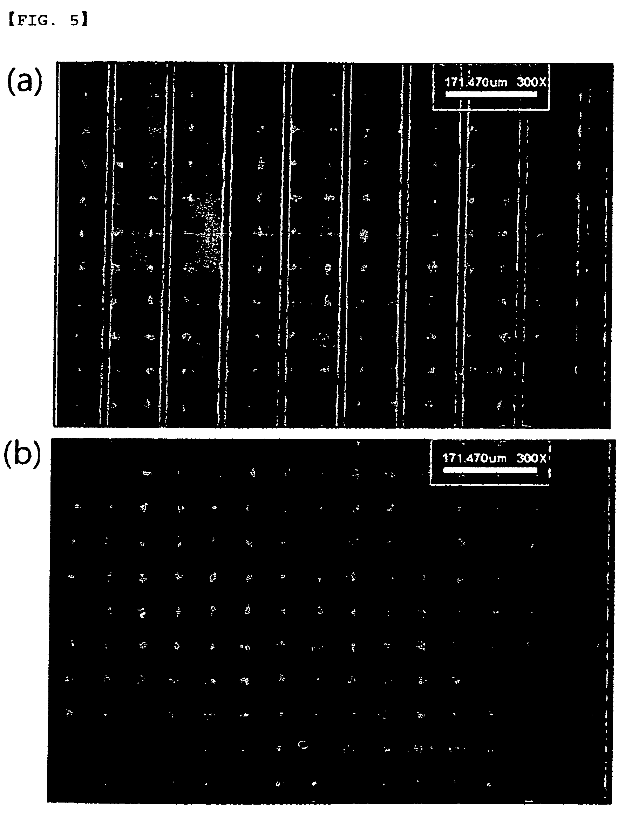

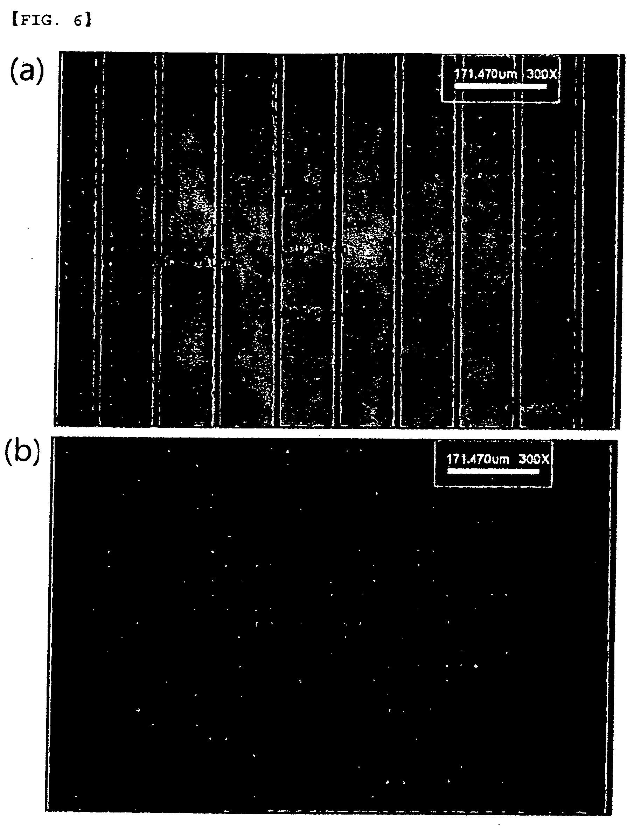

FIG. 4, FIG. 5 and FIG. 6 show observation results when a conductive ink composition according to Example 1, a conductive ink composition according to Example 2, and a conductive ink composition according to Example 3 each were reverse-offset printed on a glass substrate by using a PDMS material blanket. As shown in FIGS. 4 to 6, it can be seen that fine line patterns having a line width of about 10*µ*m were printed in a very uniform line width, and it can be confirmed that ink residues do not remain on a surface of the blanket after printing and the PDMS blanket had a smooth surface without swelling thereof.

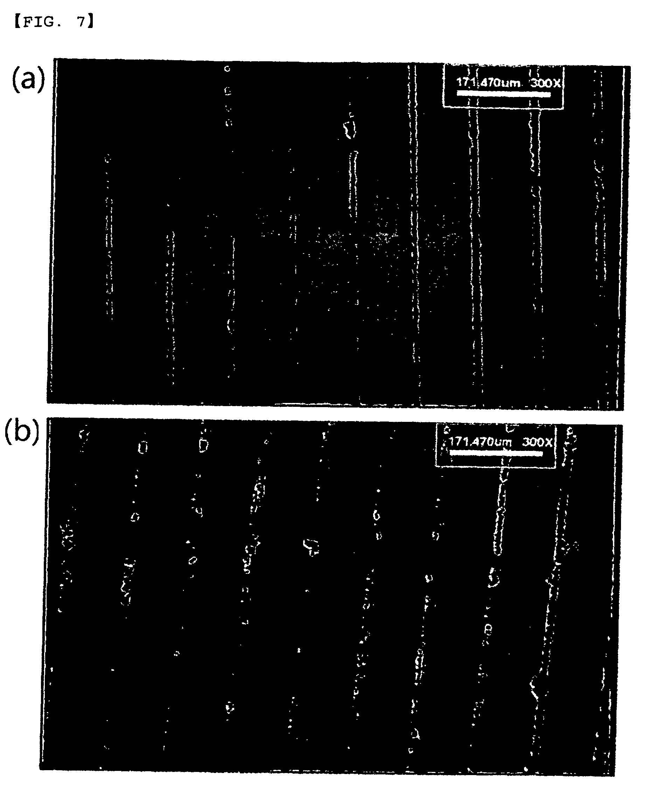

FIG. 7 shows observation results when a conductive ink composition according to Comparative example 3 was reverse-offset printed on a glass substrate by using a PDMS material blanket. As shown in FIG. 7, it can be confirmed that, in the case of the conductive ink composition of Comparative example 3 where the high boiling point solvent was not used, since the waiting time after the time when it is coated on the blanket and before the time when it is transferred onto the glass substrate was very short, all the ink on the blanket was not transferred onto the glass substrate but remained on the surface of he blanket. Further, it can be confirmed that it is difficult to print patterns in a line type and the printed patterns had very irregular line widths.

Table 1 shows test results after offset-printing each of the conductive inks prepared from Examples 1 to 3 and Comparative examples 1 to 4 on a glass substrate by using a PDMS material blanket, and performing heat treatment on the glass substrate, on which the conductive ink patterns were transferred, at 350°C in the nitrogen atmosphere for 5 minutes, in the similar manner to FIGS. 4 to 7.

**[Table 1]**

| Ink | Coatability | Transferability | swelling of blanket | Dispersion stability | binding strength to glass | waiting time | resistivity |
|---|---|---|---|---|---|---|---|
| example 1 | good | good | weak | good | 100 | 70 | 4.7 |
| example 2 | good | good | weak | good | 100 | 100 | 4.2 |
| example 3 | good | good | weak | good | 100 | 50 | 4.5 |
| Comparative example 1 | good | failed | strong | good | 100 | 10 | - |
| Comparative example 2 | failed | failed | weak | failed | 100 | - | - |
| comparative example 3 | good | good | weak | good | 100 | 10 | 4.9 |
| comparative example 4 | good | good | weak | failed | 100 | 100 | 5.1 |

In Table 1, coatability in the case where uniform coating was performed without generation of pinholes was marked as "good" and coatability in the case where pinholes were generated was marked as "failed", and transferability in the case where stable transferring was performed onto the glass substrate after the waiting time of 30 seconds, was marked as "good" and transferability in the case where stable transferring was not performed, such as, a pattern was disconnected or a line width of the pattern became thinner than the original line widths thereof was marked as "failed".

In addition, dispersion stability was evaluated by leaving an ink for 2 weeks without stirring and then taking an upper portion of the ink, followed by analysis with a thermogravimetric analyzer. Dispersion stability in the case where the metal content in the ink was reduced to 1% or less was marked as "good", and dispersion stability in the case where the metal content in the ink was reduced to 1% or more "failed".

The binding strength to the glass was expressed by a ratio at which the metal come off from the tape by the Cross-Cut Test (ASTM D3359) after the ink transferred onto the glass substrate was fired at 350°C. A case in which the metal never come off from the tape is marked by "100" and a case in which all the metal come off from the tape is marked by "0". The waiting time means the time for while stable transferring is possible after coating onto the blanket.

As described above, although the present invention is described by specific matters such as concrete components, exemplary embodiments, and drawings, they are provided only for assisting in the entire understanding of the present invention. Therefore, the present invention is not limited to the exemplary embodiments.

## Claims

1. A conductive ink composition for offset or reverse-offset printing, the conductive ink composition comprising a high boiling point solvent having a boiling point of 180 to 250°C and a dispersion assistant solvent having a boiling point of 50 to 150°C, together with metal particles and tert-butyl alcohol as a main solvent.

2. The conductive ink composition of claim 1, wherein it is printed by a polydimethylsiloxane (PDMS) material blanket.

3. The conductive ink composition of claim 1, wherein the high boiling point solvent is at least one selected from terpineol, ethyl carbitol acetate, and butyl carbitol acetate.

4. The conductive ink composition of claim 1, wherein the dispersion assistant solvent is at least one selected from acetone and propylene glycol monomethyl ether acetate.

5. The conductive ink composition of claim 1, wherein the metal particles are contained in a content of 20 to 40 wt%; the main solvent 40 to 65 wt%; the high boiling point solvent 3 to 15 wt%; and the dispersion assistant solvent 10 to 30 wt%.

6. The conductive ink composition of claim 1, wherein the metal particles are copper particles, silver particles, or mixed particles thereof, having an average particle size of 5nm to 100nm.

7. The conductive ink composition of claim 1, further comprising a binder and a dispersant.

8. The conductive ink composition of claim 7, wherein the binder is at least one selected from phenol based resin and acrylic based resin.

9. The conductive ink composition of claim 7, wherein the dispersant is a copolymer having an acid value of 50mg KOH/g or higher and an amine value of 100mg KOH/g or lower.

10. The conductive ink composition of claim 7, wherein the binder is contained in a content of 0.3 to 2 wt%; and the dispersant 1 to 5 wt%.

## Patentansprüche

1. Leitfähige Tintenzusammensetzung für Offset- oder Reverse-Offset-Druck, wobei die leitfähige Tintenzusammensetzung ein Lösungsmittel hohen Siedepunkts mit einem Siedepunkt von 180 bis 250°C und ein Dispersionsunterstützungslösungsmittel mit einem Siedepunkt von 50 bis 150°C zusammen mit Metallpartikeln und tert-Butylalkohol als Hauptlösungsmittel umfasst.

2. Leitfähige Tintenzusammensetzung nach Anspruch 1, wobei sie mit einem Tuch aus Polydimethylsiloxan(PDMS)-Material gedruckt wird.

3. Leitfähige Tintenzusammensetzung nach Anspruch 1, wobei das Lösungsmittel hohen Siedepunkts mindestens eines gewählt aus Terpineol, Ethylcarbitolacetet und Butylcarbitolacetat ist.

4. Leitfähige Tintenzusammensetzung nach Anspruch 1, wobei das Dispersionsunterstützungslösungsmittel mindestens eines gewählt aus Aceton und Propylenglykolmonomethyletheracetat ist.

5. Leitfähige Tintenzusammensetzung nach Anspruch 1, wobei die Metallpartikel mit einem Anteil von 20 bis 40 Gew.-% enthalten sind; das Hauptlösungsmittel mit 40 bis 65 Gew.-%; das Lösungsmittel hohen Siedepunkts mit 3 bis 15 Gew.-%; und das Dispersionsunterstützungslösungsmittel mit 10 bis 30 Gew.-%.

6. Leitfähige Tintenzusammensetzung nach Anspruch 1, wobei die Metallpartikel Kupferpartikel, Silberpartikel oder Mischpartikel derselben mit einer durchschnittlichen Partikelgröße von 5 nm bis 100 nm sind.

7. Leitfähige Tintenzusammensetzung nach Anspruch 1, welche weiterhin ein Bindemittel und ein Dispergiermittel umfasst.

8. Leitfähige Tintenzusammensetzung nach Anspruch 7, wobei das Bindemittel mindestens eines gewählt aus phenolbasiertem Harz und acrylbasiertem Harz ist.

9. Leitfähige Tintenzusammensetzung nach Anspruch 7, wobei das Dispergiermittel ein Copolymer mit einer Säurezahl von 50 mg KOH/g oder höher und einem Aminwert von 100 mg KOH/g oder niedriger ist.

10. Leitfähige Tintenzusammensetzung nach Anspruch 7, wobei das Bindemittel mit einem Anteil von 0,3 bis 2 Gew.-% enthalten ist; und das Dispergiermittel mit 1 bis 5 Gew.-%.

## Revendications

1. Composition d'encre conductrice pour impression offset ou offset inverse, la composition d'encre conductrice comprenant un solvant à point d'ébullition élevé ayant un point d'ébullition de 180 à 250 °C et un solvant auxiliaire de dispersion ayant un point d'ébullition de 50 à 150 °C, conjointement à des particules de métal et de l'alcool tert-butylique en tant que solvant principal.

2. Composition d'encre conductrice selon la revendication 1, étant imprimée par un blanchet en matériau polydiméthylsiloxane (PDMS).

3. Composition d'encre conductrice selon la revendication 1, le solvant à point d'ébullition élevé étant l'un au moins choisi parmi le terpinéol, l'acétate d'éthylcarbitol et l'acétate de butylcarbitol.

4. Composition d'encre conductrice selon la revendication 1, le solvant auxiliaire de dispersion étant l'un au moins choisi parmi l'acétone et l'acétate d'éther monométhylique de propylène glycol.

5. Composition d'encre conductrice selon la revendication 1, les particules métalliques étant présentes en une teneur de 20 à 40 % en poids ; le solvant principal de 40 à 65 % en poids ; le solvant à point d'ébullition élevé de 3 à 15 % en poids ; et le solvant auxiliaire de dispersion de 10 à 30 % en poids.

6. Composition d'encre conductrice selon la revendication 1, les particules métalliques étant des particules de cuivre, des particules d'argent ou des particules mélangées de celles-ci, ayant une taille moyenne de particule de 5 nm à 100 nm.

7. Composition d'encre conductrice selon la revendication 1, comprenant en outre un liant et un dispersant.

8. Composition d'encre conductrice selon la revendication 7, le liant étant l'un au moins parmi une résine à base phénolique et une résine à base acrylique.

9. Composition d'encre conductrice selon la revendication 7, le dispersant étant un copolymère ayant une valeur acide de 50 mg KOH/g ou supérieure et une valeur amine de 100 mg KOH/g ou inférieure.

10. Composition d'encre conductrice selon la revendication 7, le liant étant présent en une teneur de 0,3 à 2 % en poids ; et le dispersant de 1 à 5 % en poids.
